Europäisches Patentamt

European Patent Office

Office européen des brevets

(11) Veröffentlichungsnummer: **0 393 496 B1**

# EUROPÄISCHE PATENTSCHRIFT

(45) Veröffentlichungstag der Patentschrift: **12.01.94**

(51) Int. Cl.⁵: **H05K 1/05**, H05K 7/20

(21) Anmeldenummer: **90106975.7**

(22) Anmeldetag: **11.04.90**

(54) **Aus Kupfer- und Keramikschichten bestehendes Substrat für Leiterplatten elektrischer Schaltungen.**

(30) Priorität: **21.04.89 DE 3913161**

(43) Veröffentlichungstag der Anmeldung:
**24.10.90 Patentblatt  90/43**

(45) Bekanntmachung des Hinweises auf die
Patenterteilung:
**12.01.94 Patentblatt  94/02**

(84) Benannte Vertragsstaaten:
**BE CH DE ES FR GB IT LI NL SE**

(56) Entgegenhaltungen:
EP-A- 0 139 030          DE-A- 1 439 308
GB-A- 2 099 742          US-A- 4 563 383
US-A- 4 689 442          US-A- 4 703 395

ELECTRONIOUE INDUSTRIELLES. Nr. 107, Mai
1986, PARIS FR Seiten 62 - 67; FEDER: 'Les
supports pour circuits imprimés s'adaptent
au montage en surface'

(73) Patentinhaber: **Schulz-Harder, Jürgen, Dr.-Ing.**
**Hugo-Dietz-Strasse 32**
**D-91207 Eschenbach(DE)**

(72) Erfinder: **Schulz-Harder, Jürgen, Dr.-Ing.**
**Hugo-Dietz-Strasse 32**
**D-91207 Eschenbach(DE)**

(74) Vertreter: **Graf, Helmut, Dipl.-Ing. et al**
**Patentanwälte Wasmeier & Graf**
**Postfach 10 08 26**
**D-93008 Regensburg (DE)**

**Beschreibung**

Die Erfindung bezieht sich auf ein aus Kupfer- und Keramikschichten bestehendes Substrat entsprechend Oberbegriff Patentanspruch 1.

Bekannt ist ein mehrschichtiges Substrat, welches insbesondere für die Herstellung von Leiterplatten für elektrische Schaltkreise hoher Leistung (beispielsweise Leistungsverstärker) bestimmt ist und sich aus einer mittleren Schicht, die von zwei flächig miteinander verbundenen Zuschnitten aus einem Kupferblech gebildet ist, sowie aus zwei Keramikschichten zusammensetzt, von denen jeweils eine an jeder Oberflächenseite der mittleren Schicht vorgesehen und mit der mittleren Schicht ebenfalls flächig verbunden ist, und zwar mittels eines Verfahrens, welches unter der Bezeichnung "Direkt Bond Chopper Technology" bekannt ist und nachfolgend als "DBC-Verfahren" bezeichnet wird, vgl. z.B. GB-A-2099742 und US-A-4563383. Bei diesem Verfahren wird die Oberfläche des Kupfers mit Sauerstoff behandelt, so daß dort eine dünne Kupferoxydschicht entsteht. Diese Kupferoxydschicht bildet ein Eutektikum mit einer Schmelztemperatur unterhalb der Schmelztemperatur des Kupfers. Nach der Behandlung der Oberfläche des jeweiligen, die Kupferschicht bildenden dünnen Kupferblechs mit Sauerstoff kann letzteres mit einer weiteren Schicht, beispielsweise mit einer von einer dünnen Keramikplatte gebildeten Keramikschicht oder aber mit einer weiteren, von einem Kupferblech gebildeten Kupferschicht durch Erhitzen auf die eutektische Temperatur und durch Zusammenpressen der beiden Schichten verbunden werden. Bei dem bekannten Substrat dient die mittlere, von den beiden Zuschnitten aus Kupferblechen gebildete Schicht als Kühlschicht, die am Umfang des Substrats über die übrigen Schichten vorsteht und dort mit einem Rahmen zum Abführen der Wärme verbunden ist.

Nachteilig ist bei diesem bekannten, aus Kupfer- und Keramikschichten bestehenden mehrschichtigen Substrat unter anderem, daß mit der mittleren, von den beiden flächig miteinander verbundenen Zuschnitten aus Kupferblech gebildeten Schicht eine optimale Ableitung der Verlustwärme einer auf dem Substrat vorgesehenen elektrischen Schaltung nicht möglich ist, und daß zur Kühlung der Schaltung das Substrat mit seiner mittleren Schicht unbedingt in der vorgenannten Weise an dem wärmeabführenden Rahmen befestigt werden muß. Es bei Verwendung dieses bekannten Substrats somit beispielsweise auch nicht möglich, eine direkte, schnelle und wirksame Kühlung insbesondere im mittleren Flächenbereich des Substrates vorzunehmen. Nachteilig ist bei dem bekannten Substrat aber auch, daß insbesondere dann, wenn die in dem DBC-Verfahren miteinander zu verbindenden Kupfer- und Keramikschichten an ihren Oberflächen nicht völlig eben sind, sich zwischen zwei aneinander grenzenden Schichten im Bereich der dortigen Verbindungsebene Lunkern, d.h. Hohlräume ergeben, die Luft oder Gas enthalten und an denen eine Verbindung zwischen den benachbarten Schichten nicht vorliegt. Dies ist u.a. dadurch bedingt, daß die bei dem DBC-Verfahren als Eutektikum wirksame und durch die Behandlung der Oberfläche des Kupferbleches mit Sauerstoff erzeugte Schicht aus Kupferoxyd sehr dünn ist und somit die Vorgänge bei dem DBC-Verfahren im Bereich sehr dünner Schichten ablaufen.

Der Erfindung liegt die Aufgabe zugrunde, ein mehrschichtiges, aus Keramik- und Kupferschichten bestehendes Substrat aufzuzeigen, welches (Substrat) eine verbesserte Qualität hinsichtlich der Verbindung zwischen den einzelnen Schichten aufweist sowie auch eine verbesserte Kühlung ermöglicht.

Zur Lösung dieser Aufgabe ist ein Substrat entsprechend dem kennzeichnenden Teil des Patentanspruches 1 ausgebildet.

Auch bei der Erfindung sind die einzelnen Schichten nach dem DBC-Verfahren miteinander verbunden. Die Erfindung hat den Vorteil, daß durch die wenigstens eine, ein Hohlprofil bildende Schichtfolge zwischen den äußeren Schichten des Substrates bzw. den beiden Oberflächenseiten dieses Substrates ein Bereich erhalten ist, der insbesondere auch bei der bei dem DBC-Verfahren notwendigen Hitzebehandlung nachgiebig ist und es somit ermöglicht, daß sich die einzelnen, während des DBC-Verfahrens miteinander zu verbindenden Schichten bei diesem Verfahren bzw. bei dem hierbei auf die einzelnen Schichten ausgeübten Anpreßdruck wesentlich besser aneinander anlegen bzw. anschmiegen. Hierdurch ist eine in ihrer Qualität wesentlich verbesserte, nahezu lunkerfreie Verbindung nicht nur derjenigen Schichten, die die wenigstens eine Schichtfolge mit dem Hohlprofil bilden, sondern auch evtl. weiterer Schichten erreicht.

Bei der Erfindung bestehen die Kupferschichten wiederum aus Zuschnitten aus Kupferblech, wobei für die wenigstens eine, das Hohlprofil bildende Schichtfolge beispielsweise eine gewelltes oder beidseitig mit Vorsprüngen oder mit vorstehenden Noppen versehenes Kupferblech oder aber ein mehrfach abgewinkeltes Kupferrohr verwendet wird.

Durch die wenigstens eine, das Hohlprofil bildende Schichtfolge weist das erfindungsgemäße Substrat im Inneren Kanäle auf, die in optimaler Weise für den Durchtritt eines Kühlmediums, beispielsweise Kühlluft oder eine Kühlflüssigkeit verwendet werden können, so daß eine schnelle und vor allem auch wirksame Kühlung selbst der mittleren Flächenzonen des Substrates möglich ist.

Weiterbildungen der Erfindung sind Gegenstand der Unteransprüche.

Die Erfindung wird im folgenden anhand der Figuren an Ausführungsbeispielen näher erläutert. Es zeigen:

Fig. 1 - 6    den Schichtaufbau bzw. einen Schnitt durch verschiedene Substrate gemäß der Erfindung;

Fig. 7    eine Draufsicht auf eine spezielle Ausbildung eines Substrates gemäß der Erfindung;

Fig. 8    einen Schnitt entsprechend der Linie I-I der Fig. 7;

Fig. 9 und 10    den Schichtaufbau bzw. den Schnitt weiterer Substrate gemäß Erfindung;

Fig. 11    in schematischer Darstellung und in Draufsicht die das Hohlprofil bildende Schichtfolge des Substrates gemäß Fig. 10.

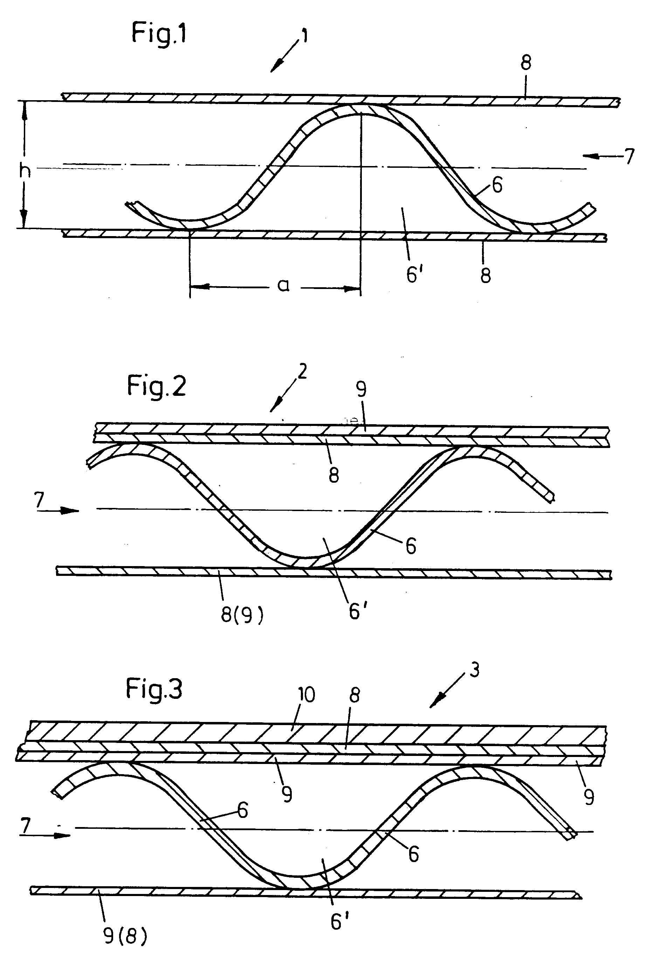

Den in den Figuren 1 - 5 dargestellten Ausführungsformen bzw. den dortigen Substraten 1 - 5 ist hinsichtlich ihres Schichtaufbaus gemeinsam, daß eine Schicht des Substrates 1 - 5 ein gewelltes Kupferblech 6 ist, welches mit zwei angrenzenden Schichten eine Schichtfolge 7 bzw. durch seine Wellung im Inneren des Substrates ein Hohlprofil mit einer Vielzahl von Kühlkanälen 6' bildet. Die Wellung des Kupferbleches 6 kann die unterschiedlichste Form aufweisen, d.h. diese Wellung kann sinusartig, annähernd sinusartig, trapezartig, dreieckförmig usw. ausgebildet sein. Den Substraten 1 - 5 ist weiterhin gemeinsam, daß das gewellte Kupferblech 6 jeweils im Bereich der Maximas dieser Wellung mit den angrenzenden Schichten des Substrates verbunden ist.

Die Materialdicke des gewellten Kupferbleches 6 liegt vorzugsweise in der Größenordnung zwischen 0,05 - 0,5 mm, wobei die Dicke auch der übrigen Schichten des jeweiligen Substrates 1 - 5 und dabei insbes. die Dicke eventueller Kupferschichten vorzugsweise in der gleichen Größenordnung liegt. Die Wellung der gewellten Kupferschicht 6 ist vorzugsweise so ausgeführt, daß die Höhe h dieser Wellung, d.h. der Abstand zweier aufeinanderfolgender, entgegengesetzter Maximas in Richtung senkrecht zur Ebene des gewellten Kupferbleches 6 sowie der Abstand a zweier gleichgerichteter Maximas der Wellung in Richtung der vorgenannten Ebene in einem Verhältnis $V = h/a$ zueinander stehen, wobei V vorzugsweise zwischen 0,1 und 10 liegt.

Allen Substraten 1 - 5 der Figuren 1 - 5 ist weiterhin gemeinsam, daß dort sämtliche Schichten jeweils durch das DBC-Verfahren miteinander verbunden sind.

Allen in den Figuren 1 - 5 dargestellten Substraten 1 - 5 ist weiterhin gemeinsam, daß sämtliche, diese Substrate jeweils bildenden Schichten parallel zueinander und parallel zur Ebene des gewellten Kupferbleches 6 liegen.

Bei dem Substrat 1 der Fig. 1 schließt sich beidseitig an das gewellte Kupferblech 6 eine Schicht an, die von einer dünnen Keramikplatte 8 gebildet ist, die vorzugsweise auf $Al_2O_3$-Keramik oder AlN-Keramik gebildet ist.

Auf die dem gewellten Kupferblech 6 abgewendete Oberflächenseite wenigstens einer der beiden, parallel zueinander und im Abstand voneinander angeordneten Keramikschichten 8 werden bei der Herstellung einer Leiterplatte Leiterbahnen in geeigneter Form und mit bekannten Techniken aufgebracht, oder aber dadurch aufgebracht, daß auf die betreffende Oberflächenseite ein die Leiterbahnen aufweisender bzw. bildender Zuschnitt aus einer Kupferplatte aufgebracht wird, und zwar ebenfalls durch das DBC-Verfahren.

Das Substrat 2 nach Fig. 2 unterscheidet sich von dem Substrat 1 im wesentlichen nur dadurch, daß auf die dem gewellten Kupferblech 6 abgewendete Oberflächenseite einer der Keramikschichten 8 der Schichtfolge 7 ein von einem dünnen Kupferblech gebildete Kupferschicht 9 aufgebracht ist. Dieser Kupferschicht 9 kann dann beispielsweise zum Herstellen von Leiterbahnen vorzugsweise unter Verwendung der üblichen Maskierungs- und Ätz-Techniken dienen. Die Kupferschicht 9 kann aber auch dazu verwendet werden, um das an seiner anderen Seite auf der dortigen Keramikschicht 8 mit Leiterbahnen und elektronischen Leistungsbauelementen versehene Substrat beispielsweise an einem Kühlkörper zu befestigen. Das Substrat 2 kann auch so ausgebildet sein, daß anstelle der in der Fig. 2 unteren Keramikschicht 8 ebenfalls eine von dem Kupferblech gebildete Kupferschicht 9 vorgesehen ist.

Das Substrat 3 der Fig. 3 besteht wiederum aus dem gewellten Kupferblech 6, an welches sich beidseitig jeweils von einem Kupferblech gebildete Kupferschicht 9 anschließt. Auf die dem gewellten Kupferblech 6 abgewendete Oberflächenseite der in der Fig. 3 oberen Kupferschicht 9 ist die Keramikschicht 8 und auf diese eine weitere Kupferschicht 10 aufgebracht, welche von einem Kupferblech gebildet ist, das eine etwas größere Dicke als das die Kupferschichten 9 bildende Kupferblech besitzt.

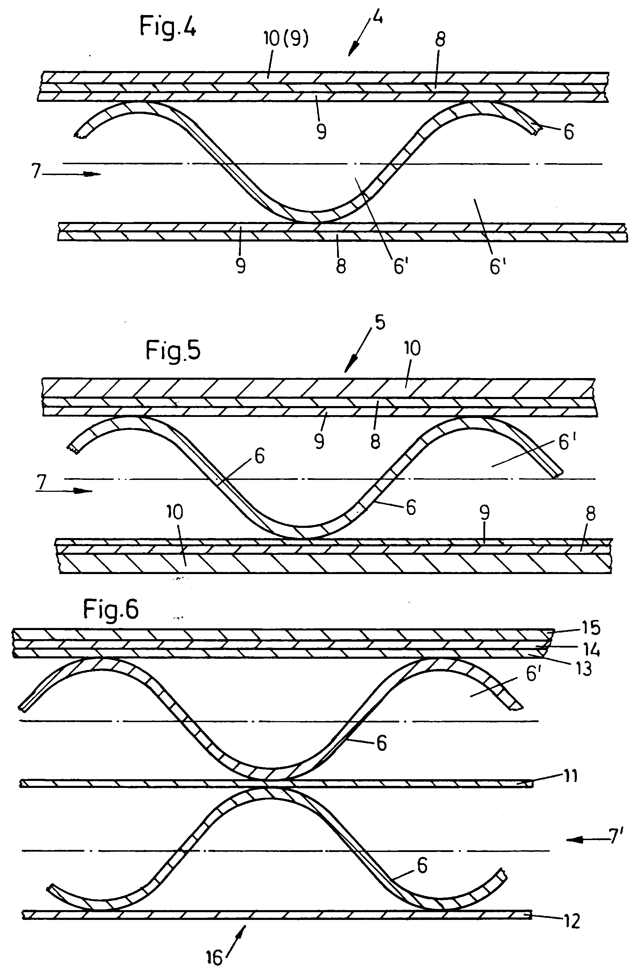

Das Substrat 4 der Fig. 4 unterscheidet sich von dem Substrat 3 im wesentlichen dadurch, daß auf die bei der gewellten Darstellung untere Kupferschicht noch eine Keramikschicht 8 aufgebracht ist.

Das Substrat 5 der Fig. 5 entspricht hinsichtlich seines Aufbaus dem Substrat 4, allerdings mit dem Unterschied, daß auch auf die bei der gewählten Darstellung unterste Keramikschicht 8 noch die Kupferschicht 10 aufgebracht ist, so daß das Substrat 5 hinsichtlich seines Schichtaufbaus bezüglich der Ebene des gewellten Kupferbleches 6 völlig symmetrisch ist.

Selbstverständlich ist es möglich, bei den Substraten 2 - 5 die Folge von Keramikschicht 8 und Kupferschicht 9 bzw. 10 zu vertauschen, um so das jeweilige Substrat dem jeweiligen Anwendungsfall optimal anzupassen.

Fig. 6 zeigt den Aufbau eines Substrates 16 mit einer das Hohlprofil bildenden Schichtfolge 7′, die zwei gewellte Kupferbleche 6 aufweist, die beidseitig von einer Zwischenschicht 11 vorgesehen sind. Diese Zwischenschicht 11 kann entweder eine Keramikschicht 8 oder eine Kupferschicht 9 sein. Beidseitig auf die von den beiden Kupferblechen 6 und der Zwischenschicht 11 gebildete Anordnung sind dann zwei weiter Schichten 12 und 13 aufgebracht, die zusammen mit den Kupferblechen 6 und der Zwischenschicht die Schichtfolge 7′ bildet. An die Schicht 13 schließen sich weitere Schichten 14 und 15 an. Die Schicht 12 ist entweder eine Keramikschicht 8 oder eine Kupferschicht 9. Die Schichten 13 - 15 sind abwechselnd jeweils eine Keramikschicht 8 und eine Kupferschicht 9 bzw. 10.

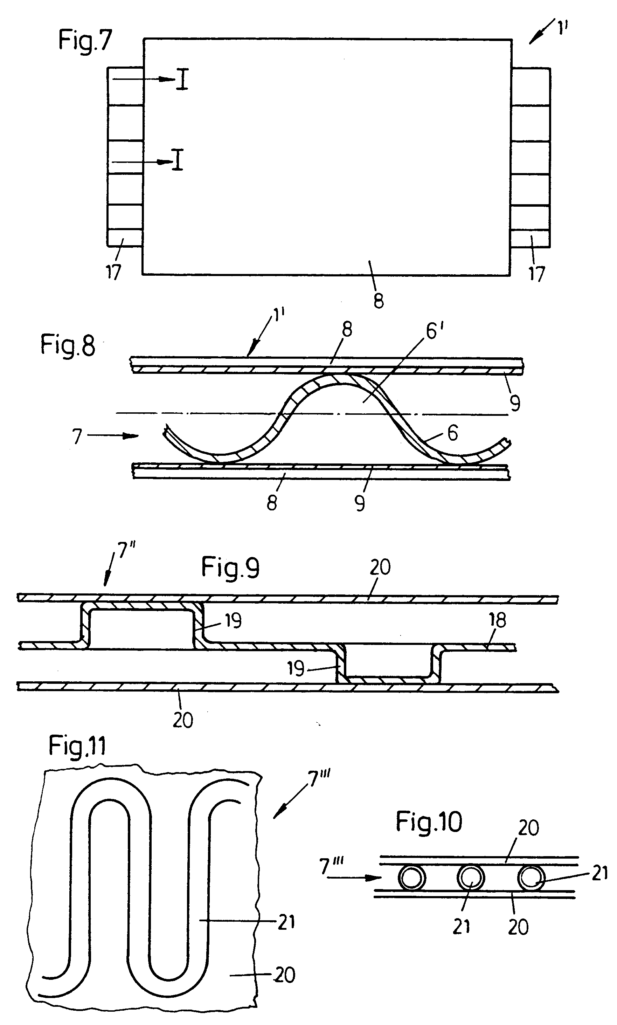

Figuren 7 und 8 zeigen ein Substrat 1′, bei welchem die das Hohlprofil aufweisende Schichtfolge 7 wiederum von dem gewellten Kupferblech 6 sowie zwei anschließenden Schichten, vorzugsweise von zwei Kupferschichten 9 gebildet sind, wobei bei der dargestellten Ausführungsform auf die dem gewellten Kupferblech 6 abgewendete Seite beider Kupferschichten 9 jeweils eine Keramikschicht 8 aufgebracht ist. Wie die Fig. 7 zeigt, steht die von dem gewellten Kupferblech 6 und den anschließenden Kupferschichten 9 gebildete Schichtfolge an zwei einander gegenüberliegenden Seiten des bei der dargestellten Ausführungsform einen rechteckförmigen Zuschnitt aufweisenden Substrats 1′ über die beiden Keramikschichten 8 weg, so daß diese überstehenden Bereiche 17 als Anschlußstutzen zum Anschließen an einen Kühlmittelkreislauf (z.B. Kreislauf für Kühlluft oder eine Kühlflüssigkeit) dienen können. Selbstverständlich ist es auch möglich, daß die Schichtfolge 7 an nur einer oder aber an mehr als zwei Seiten des Substrates 1′ über die übrigen Schichten wegsteht. Weiterhin kann anstelle der Schichtfolge 7 auch die Schichtfolge 7′ verwendet sein, oder der Schichtaufbau des Substrates kann an einer oder aber an beiden Seiten der Schichtfolge 7 bzw. 7′ auch unterschiedlich von dem in den Figuren 7 und 8 gezeigten Aufbau sein.

Fig. 9 zeigt als weitere Ausbildung die das Hohlprofil bildende Schichtfolge 7″ eines ansonsten nicht weiter dargestellten Substrats. Die Schichtfolge 7″ besteht aus einem Kupferblech 18, welches an beiden Oberflächenseiten eine Vielzahl von Noppen 19 aufweist, die über diese Oberflächenseiten wegstehen. Beidseitig von der Kupferplatte 18 ist jeweils eine Schicht 20 vorgesehen, die auf den Noppen 19 aufliegt und im Bereich dieser Noppen mit der Kupferplatte 18 verbunden ist. Die beiden parallel zueinander und im Abstand voneinander angeordneten Schichten 20 sind entweder jeweils eine Keramikschicht oder eine Kupferschicht. Grundsätzlich kann auch eine Schicht 20 eine Keramikschicht und eine Schicht 20 eine Kupferschicht sein. Auf wenigstens eine der beiden Schichten 20 ist dann bevorzugt wenigstens eine weitere Schicht aufgebracht, die bei Ausbildung der Schicht 20 als Kupferschicht eine Keramikschicht bzw. bei Ausbildung der Schicht 20 als Keramikschicht eine Kupferschicht ist.

Figuren 10 und 11 zeigen die das Hohlprofil bildende Schichtfolge 7‴ einer weiteren Ausführungsform, die sich von der Schichtfolge 7″ dadurch unterscheidet, daß zwischen den beiden Schichten 20 anstelle der Kupferschicht 18 ein schlangen- oder meanderartig gebogenes Kupferrohr 21 vorgesehen ist, mit welchem die beiden Schichten 20 verbunden sind.

Auch bei dem Substrat 18 der Figuren 7 und 8 sowie bei den die Schichtfolgen 7″ und 7‴ aufweisenden Substraten der Figuren 9 bis 11 sind die einzelnen Schichten einschließlich des jeweiligen Kupferbleches 6 bzw. 18 durch das DBC-Verfahren miteinander verbunden. Bei allen vorbeschriebenen Ausführungsformen wirkt die Schichtfolge 7, 7′, 7″ bzw. 7‴ bei der Herstellung des jeweiligen Substrates als nachgiebige Substratschicht, so daß mit dem DBC-Verfahren eine gleichmäßige Verbindung der einzelnen Schichten mit hoher Qualität und insbesondere auch ohne Lunkern sichergestellt ist, wobei das von der Schichtfolge 7, 7′, 7″ bzw. 7‴ gebildete Hohlprofil bzw. dessen Kanäle in besonders vorteilhafter Weise auch zum Kühlen Verwendung finden können.

Die Erfindung wurde voranstehend an Ausführungsbeispielen beschrieben. Es versteht sich, daß Änderungen sowie Abwandlungen möglich sind, ohne daß dadurch der der Erfindung zugrundeliegende Gedanke verlassen wird. So ist es beispielsweise möglich, die das Hohlprofil bildende Schichtfolge auch dadurch herzustellen, daß ein eine Kupferschicht bildendes Kupferblech verwendet wird, in welches Kanäle bildende Sicken eingedrückt sind.

**Patentansprüche**

1.  Aus Kupfer- und Keramikschichten bestehendes mehrschichtiges Substrat für Leiterplatten elektrischer Schaltungen, bei welchem (Substrat) die jeweils von einem Kupferblech oder einer Keramikplatte gebildeten Schichten mittels des DBC-Verfahrens miteinander zu dem mehrschichtigen Substrat verbunden sind, welches zumindest eine aus wenigstens zwei Schichten bestehende Schichtfolge aufweist, dadurch gekennzeichnet, daß die Schichtfolge (7, 7′, 7″, 7‴) als Hohlprofil ausgebildet ist, in welchem die wenigstens zwei Schichten (8, 9; 12, 13; 20) der Schichtfolge (7, 7′, 7″, 7‴) im wesentlichen parallel zu und im Abstand voneinander vorgesehen sind.

2. Substrat nach Anspruch 1, dadurch gekennzeichnet, daß zur Bildung der als Hohlprofil ausgeführten Schichtfolge (7, 7′, 7″, 7‴) zwischen den wenigstens zwei Schichten (8, 9; 12, 13; 20) mindestens eine Zwischenschicht (6, 18, 21) vorgesehen ist, wobei wenigstens ein gewelltes Kupferblech (6) als Zwischenschicht verwendet ist.

3. Substrat nach Anspruch 2, gekennzeichnet durch Verwendung wenigstens eines an beiden Oberflächenseiten mit Vorsprüngen, vorzugsweise mit noppenartigen Vorsprüngen (19) versehenen Kupferbleches (18) als Zwischenschicht.

4. Substrat nach Anspruch 2 oder 3, gekennzeichnet durch die Verwendung einer mehrfach gebogenen, vorzugsweise schlangen- oder meanderartig gebogenen Länge eines Kupferrohres (21) als Zwischenschicht.

5. Substrat nach einem der Ansprüche 1 bis 4, dadurch gekennzeichnet, daß wenigstens eine der beiden Schichten der wenigstens einen Schichtfolge an einer Oberflächenseite mit Vorsprüngen versehen ist.

6. Substrat nach einem der Ansprüche 1 bis 5, dadurch gekennzeichnet, daß die als Hohlprofil ausgebildete Schichtfolge (7′) wenigstens zwei Zwischenschichten aufweist, die vorzugsweise jeweils von einem gewellten Kupferblech (6) gebildet sind, und daß vorzugsweise zwischen jeder als Abstandshalter wirkenden Zwischenschicht eine weitere, ebene Zwischenschicht (11) vorgesehen ist.

7. Substrat nach einem der Ansprüche 1 bis 6, dadurch gekennzeichnet, daß wenigstens eine der beiden Schichten der Schichtfolge (7, 7′, 7″, 7‴) ein eine Kupferschicht (9) bildendes Kupferblech ist.

8. Substrat nach einem der Ansprüche 1 bis 7, dadurch gekennzeichnet, daß für wenigstens eine der beiden Schichten der Schichtfolge (7, 7′, 7″, 7‴) eine eine Keramikschicht (8) bildende Keramikplatte verwendet ist.

9. Substrat nach einem der Ansprüche 1 bis 8, dadurch gekennzeichnet, daß wenigstens eine Schicht (8, 9; 12, 13; 20) der Schichtfolge (7, 7′, 7″, 7‴) mit wenigstens einer weiteren Schicht (8, 9, 10; 14, 15) eine weitere Schichtfolge mit wenigstens zwei ebenen Schichten bildet, von denen eine eine Keramikschicht (8) und eine eine Kupferschicht (9, 10) ist.

10. Substrat nach einem der Ansprüche 1 bis 9, dadurch gekennzeichnet, daß an wenigstens einem Teilbereich der Umfangslinie des Substrats (1′) die das Hohlprofil bildende Schichtfolge (7) mit einem Teilabschnitt (17) über die übrigen Schichten (8) des Substrats (1′) vorsteht.

**Claims**

1. Substrate for circuit board electrical connections consisting of copper and ceramic layers, by which substrate the layers, each formed from a copper sheet or a ceramic slab, are connected, by means of the DBC-method, together to the multilayered substrate, which at least displays a layer arrangement consisting of at least two layers, characterised in that the layer arrangement (7, 7', 7'', 7''') is formed as a hollow section, in which the at least two sheets (8, 9; 12, 13; 20) of the layer arrangement (7, 7', 7'', 7''') are arranged substantially parallel to and at a distance from each other.

2. Substrate according to claim 1, characterised in that for the formation of the layer arrangement (7, 7', 7'', 7''') implemented as a hollow section, between the at least two layers (8, 9; 12, 13; 20) at least one intermediate layer (6, 18, 21) is provided, whereby at least one corrugated copper sheet (6) is used as the intermediate layer.

3. Substrate according to claim 2, characterised through the use at least of one copper sheet (18) as the intermediate layer, provided on both surface sides with projections, preferably with knob like projections.

4. Substrate according to claim 2 or 3, characterised through the use of a multiply bent length of a copper pipe (21) as the intermediate layer, preferably bent in a serpentine or meander like way.

**5.** Substrate according to one of claims 1 to 4, characterised in that at least one of the both layers of the at least one layer arrangement is provided on a surface side with projections.

**6.** Substrate according to one of claims 1 to 5, characterised in that the layer arrangement (7'), formed as a hollow section, displays at least two intermediate layers, preferably each formed from a corrugated copper sheet (6) and that preferably between each intermediate layer, working as a spacer, a further flat intermediate layer (11) is provided.

**7.** Substrate according to one of claims 1 to 6, characterised in that at least one of the both layers of the layer arrangement (7, 7', 7'', 7''') is a copper layer (9) formed of a copper sheet.

**8.** Substrate according to one of claims 1 to 7, characterised in that for at least one of the both layers of the layer arrangement (7, 7', 7'', 7''') is a ceramic layer (8) formed of a ceramic slab.

**9.** Substrate according to one of claims 1 to 8 characterised in that at least one layer (8, 9; 12, 13; 20) of the layer arrangement (7, 7', 7'', 7''') is provided with at least a further layer (8, 9, 10; 14, 15) forming a further layer arrangement with at least two flat layers, of which one is a ceramic layer (8) and one is a copper layer (9, 10).

**10.** Substrate according to one of claims 1 to 9, characterised in that on at least one section of the peripheral line of the substrate (1') the hollow section formed layer arrangement (7) projects with a section (17) beyond the remaining layers (8) of the substrate (1').

**Revendications**

**1.** Substrat à plusieurs couches pour plaques de circuits électriques, composé de couches de cuivre et de couches de céramique, dans lequel (substrat) les couches formées chaque fois par une tôle de cuivre ou une plaque de céramique sont raccordées ensemble au moyen du procédé DBC en substrat à plusieurs couches qui comporte au moins une suite de couches constituée d'au moins deux couches, caractérisé en ce que la suite de couches (7, 7', 7'', 7''') est agencée sous forme de profilé creux dans lequel les couches (8, 9; 12, 13; 20) (au moins deux) de la suite de couches (7, 7', 7'', 7''') sont prévues avec une disposition sensiblement parallèle de l'une par rapport à l'autre et à distance l'une de l'autre.

**2.** Substrat selon la revendication 1 caractérisé en ce qu'on prévoit, pour la formation de la suite de couches (7, 7', 7'', 7''') réalisée sous forme de profilé creux, au moins une couche intermédiaire (6, 18, 21) entre les couches (8, 9; 12, 13; 20) (au moins deux), une tôle de cuivre ondulée (6) au moins étant utilisée comme couche intermédiaire.

**3.** Substrat selon la revendication 2 caractérisé par l'utilisation d'une tôle de cuivre (18) munie aux deux faces de saillies, de préférence de saillies sous forme de bosses (19), en tant que couche intermédiaire.

**4.** Substrat selon la revendication 2 ou 3 caractérisé par l'utilisation d'une longueur d'un tube de cuivre (21), plusieurs fois recourbée, de préférence avec des sinuosités ou des méandres, en tant que couche intermédiaire.

**5.** Substrat selon l'une des revendications 1 à 4 caractérisé en ce qu'au moins une des deux couches de la suite de couches (au moins une) est munie de saillies à une face.

**6.** Substrat selon l'une des revendications 1 à 5 caractérisé en ce la suite de couches (7') agencée sous forme de profilé creux comporte au moins deux couches intermédiaires qui sont de préférence formées chacune par une tôle de cuivre ondulée (6) et on prévoit de préférence entre chaque couche intermédiaire agissant comme écarteur une autre couche intermédiaire plane (11).

**7.** Substrat selon l'une des revendications 1 à 6 caractérisé en ce qu'au moins l'une des deux couches de la suite de couches (7, 7', 7'', 7''') est une tôle de cuivre formant une couche de cuivre (9).

**8.** Substrat selon l'une des revendications 1 à 7 caractérisé en ce qu'on utilise une plaque de céramique formant une couche de céramique (8) pour au moins l'une des deux couches de la suite de couches (7, 7', 7'', 7''').

**9.** Substrat selon l'une des revendications 1 à 8 caractérisé en ce qu'au moins une couche (8, 9; 12, 13; 20) de la suite de couches (7, 7', 7'', 7''') forme avec au moins une autre couche (8, 9, 10; 14, 15) une autre suite de couches avec au moins deux couches planes dont l'une est une couche de céramique (8) et l'autre une couche de cuivre (9, 10).

10. Substrat selon l'une des revendications 1 à 9 caractérisé en ce qu'au moins à une région partielle de la ligne périphérique du substrat (1'), la suite de couches (7) formant le profilé creux fait saillie avec un segment partiel (17) par rapport aux couches restantes (8) du substrat (1').

Fig.1

Fig.2

Fig.3

Fig.4

Fig.5

Fig.6

Fig.7

Fig.8

Fig.9

Fig.10

Fig.11